# EUROPÄISCHE PATENTSCHRIFT

(11) **EP 1 440 481 B1**
(45) Veröffentlichungstag und Bekanntmachung des Hinweises auf die Patenterteilung: **19.09.2007**
(21) Anmeldenummer: 02776861.3
(22) Anmeldetag: 28.10.2002
(51) Int. Cl.: H01L 33/00, H01L 31/0203

(54) **OPTOELEKTRONISCHES BAUELEMENT**
OPTOELECTRONIC COMPONENT
COMPOSANT OPTOELECTRONIQUE

(30) Priorität: 31.10.2001 DE 10153259
(43) Veröffentlichungstag der Anmeldung: 28.07.2004
(73) Patentinhaber: Osram Opto Semiconductors GmbH, 93049 Regensburg (DE)
(72) Erfinder: BOGNER, Georg, 93138 Lappersdorf (DE); BRUNNER, Herbert, 93049 Regensburg (DE); KRÄUTER, Gertrud, 93053 Regensburg (DE); WAITL, Günter, 93049 Regensburg (DE)
(74) Vertreter: Epping - Hermann - Fischer
(86) Internationale Anmeldenummer: PCT/DE2002/004025
(87) Internationale Veröffentlichungsnummer: WO 2003/038912

(56) Entgegenhaltungen:
- EP-A- 0 854 523
- EP-A- 1 246 265
- EP-A1- 1 187 228
- WO-A-01/22501
- WO-A-97/50132
- US-A- 4 152 624
- US-A- 4 827 118
- US-A- 5 798 536
- DATABASE WPI Section Ch, Week 197928 Derwent Publications Ltd., London, GB; Class A23, AN 1979-51696B XP002264912 & JP 54 069067 A (TEIJIN LTD), 2. Juni 1979 (1979-06-02)
- LUCKIESH M.: 'Spectral reflectance of common materials in the UV region' J. OPTICAL SOCIETY OF AMERICA, 1929 Bd. 19, Nr. 1, 1929, Seiten 1 - 6
- EGAN W. ET AL: 'Integrating spheres for measurements between 0.185 µm and 12 µm' APPLIED OPTICS Bd. 14, Nr. 5, 1975, Seiten 1137 - 1142

## Beschreibung

Die Erfindung betrifft ein optoelektronisches Bauelement, insbesondere ein strahlungsemittierendes, vorzugsweis oberflächenmontierbares Bauelement, nach dem Oberbegriff von Patentanspruch 1.

Unter den Begriff "Umhüllungsmaterial" fällt im vorliegenden Zusammenhang insbesondere jedes Material, das mittels Giessen, Spritzen, Spritzgiessen oder Spritzpressen in eine vorgesehene Form gebracht werden kann. Hierzu gehören insbesondere Reaktionsharze, wie Epoxidharze, Acrylharze und Silikonharze. Denkar ist auch die Verwendung von keramischen oder glasartigen Materialien.

Bei herkömmlichen oberflächenmontierbaren optoelektronischen Bauelementen wird zunächst ein vorgehäustes Bauteil dadurch hergestellt, dass ein vorgefertigter Leiterrahmen (Leadframe) mit einem geeigneten Kunststoffmaterial umspritzt wird, welches einen Gehäusekörper des Bauteils bildet. Dieser Gehäusekörper weist zum Beispiel an der Oberseite eine Vertiefung auf, in die von zwei gegenüberliegenden Seiten Leadframe-Anschlüsse eingeführt sind. Auf einem dieser Leadframe-Anschlüsse ist ein Halbleiterchip wie beispielsweise ein LED-Chip aufgeklebt und elektrisch kontaktiert. Der andere Leadframe-Anschluß ist über einen Bonddraht mit dem Halbleiterchip verbunden. In die Vertiefung ist eine in der Regel transparente Vergussmasse eingefüllt. Diese Grundform von oberflächenmontierbaren optoelektronischen Bauelementen ist beispielsweise aus dem Artikel "SIEMENS SMT-TOPLED für die Oberflächenmontage" von F. Möllmer und G. Waitl, Siemens Components 29 (1991), Heft 4, Seiten 147-149, bekannt.

Bei diesen bekannten oberflächenmontierbaren Bauformen kann eine sehr gerichtete Abstrahlung dadurch erreicht werden, dass die Seitenwände der Vertiefung derart ausgebildet sind, beispielsweise als geeignet schräggestellte oder gekrümmte Flächen, dass sie für eine vom Halbleiterchip seitlich oder nach rückwärts ausgesandte Strahlung einen Reflektor ausbilden, der diese Strahlung zur gewünschten Abstrahlungsrichtung hin umlenkt. Je nach Gehäuseform bzw. Reflektorform kann das Bauelement als sogenannter Toplooker, d.h. mit einer Hauptabstrahlrichtung senkrecht oder in einem steilen Winkel zur Montageebene des Bauelements, oder als sogenannter Sidelooker, d.h. mit einer Hauptabstrahlrichtung parallel oder in einem flachen Winkel zur Montageebene des Bauelements, konstruiert werden. Beispiele eines Toplookers und eines Sidelookers mit den entsprechenden Gehäuseformen sind zum Beispiel in FIG 2 bzw. FIG 3 der EP 0 400 175 A1 gezeigt.

Als Material für den Gehäusekörper des Bauelements wird üblicherweise ein Thermoplastmaterial oder ein Duroplastmaterial verwendet. In einer bevorzugten Ausführungsform, die in der Praxis eingesetzt wird, verwendet man als Kunststoffmaterial für den Gehäusekörper ein mit Glasfasern gefülltes Polyphtalamid, das mit einem TiO₂-Füllstoff weiß eingefärbt ist.

Der Vollständigkeit halber sei noch darauf hingewiesen, dass es außerdem bekannt ist, derartige optoelektronische Bauelemente mit zusätzlichen optischen Elementen auszubilden, um ihre Abstrahlcharakteristik zu verbessern bzw. an spezielle Anwendungsfälle anzupassen. So zeigen zum Beispiel die EP 0 400 176 A1 und die DE 197 55 734 A1 oberflächenmontierbare optoelektronische Bauelemente der eingangs beschriebenen Art, die jeweils mit einer zusätzlichen optischen Einrichtung auf dem Gehäusekörper und/oder der Vergussmasse versehen sind.

Es wurde festgestellt, dass bei Verwendung von Halbleiterchips, die Strahlung aus dem blauen Spektralbereich und/oder aus dem ultravioletten Spektralbereich emittieren, insbesondere GaN-basierte Halbleiterchips, bei denen eine strahlungsemittierende aktive Schicht ein GaN-,InGaN-, AlGaN- oder InAlGaN-Material aufweist, die Strahlungsausbeute aus dem Bauelement unerwartet niedrig ist.

EP 0854523 A offenbart ein optoelektronisches Bauelement mit einem aus einem Kunststoffmaterial gefertigten Gehäusekörper, der eine Ausnehmung aufweist, und einem in der Ausnehmung angeordneten optoelektronischen Halbleiterchip, wobei das Kunststoffmaterial SiO₂, Al₂O₃ oder eine Mischung dieser Materialien oder ZnO als Füllstoff enthält.

Der vorliegenden Erfindung liegt die Aufgabe zugrunde, ein optoelektronisches Bauelement der eingangs genannten Art mit einem ultraviolette und/oder blaue Strahlung aussendenden und/oder empfangenden Chip derart weiterzubilden, dass die Strahlungsausbeute aus dem Bauelement verbessert ist.

Eine weitere Aufgabe der vorliegenden Erfindung besteht darin, ein optoelektronisches Bauelement der eingangs genannten Art zu entwickeln, bei dem der Gehäusekörper alterungsstabil ist, das heißt weitestgehend keine Degradation aufweist.

Diese Aufgaben werden durch ein optoelektronisches Bauelement mit den Merkmalen des Patentanspruches 1 gelöst. Vorteilhafte Weiterbildungen der Erfindung sind in den Unteransprüchen 2 bis 12 angegeben.

Gemäß der vorliegenden Erfindung wird der Gehäusekörper des optoelektronischen Bauelements aus einem Kunststoffmaterial mit einem Füllstoff gebildet, wobei der Füllstoff ein hohes Reflexionsvermögen in einem Wellenlängenbereich unterhalb von etwa 500 nm aufweist. Ein "hohes" oder "gutes" Reflexionsvermögen liegt im Zusammenhang der vorliegenden Anmeldung dann vor, wenn der Füllstoff für elektromagnetische Strahlung aus dem Wellenlängenbereich einen Reflexionsgrad von größer als oder gleich 0,5, insbesondere von größer als oder gleich 0,7 aufweist.

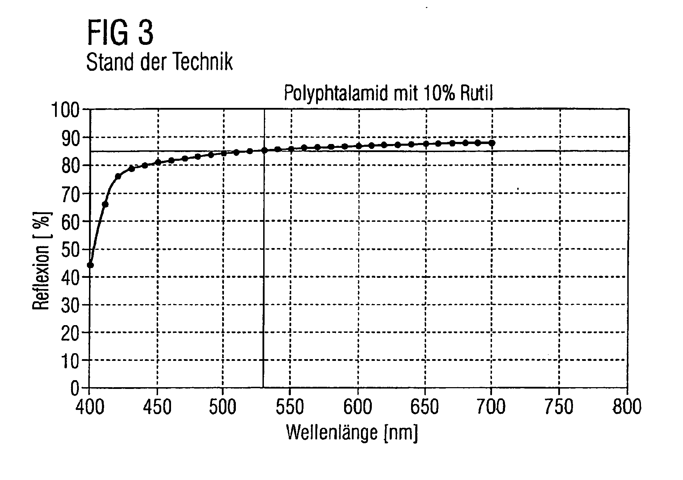

Der Erfindung liegt die Erkenntnis zugrunde, dass bei den herkömmlicherweise verwendeten Materialien für den Gehäusekörper der optoelektronischen Bauelemente der Füllstoff, d.h. im oben beschriebenen Fall der weiß färbende TiO₂-Füllstoff, die Strahlungsausbeute aus einem Bauelement wesentlich beeinflusst. Wie in den FIG 2C und 3 dargestellt, weist der TiO₂-Füllstoff oberhalb von etwa 480 bis 500 nm ein gutes Reflexionsvermögen auf. Für kleinere Wellenlängen nimmt das Reflexionsvermögen stark ab, so dass ein bedeutender Anteil des auf den Gehäusekörper treffenden Lichts in diesem unteren Wellenlängenbereich von diesem absorbiert wird und somit der Wirkungsgrad des Bauelements in diesem Wellenlängenbereich deutlich abnimmt. Des weiteren trägt die durch den Füllstoff absorbierte Energie zum Alterungsprozess des Kunststoffmaterials bei.

Verwendet man, wie gemäß der vorliegenden Erfindung vorgeschlagen, einen Füllstoff, der auch in einem Wellenlängenbereich unterhalb von etwa 500 nm ein hohes Reflexionsvermögen aufweist, so wird dadurch einerseits der Wirkungsgrad des optoelektronischen Bauelements in den Wellenlängenbereichen unterhalb von 500 nm erhöht und andererseits der Gehäusekörper gegen Alterung geschützt.

Geeignete Füllstoffe sind Anatas (dies ist eine Modifikation von TiO₂) und Teflon (PTFE), die vorzugsweise mit einem Volumenanteil von bis zu 50% zugesetzt sind. Ein weiterhin bevorzugter Volumenanteil liegt im Bereich zwischen etwa 5 % und etwa 15 %. "Teflon" ist ein eingetragenes Warenzeichen des Unternehmens DuPont. Als zusätzlicher Füllstoff ist beispielsweise Bariumsulfat geeignet.

Für das Kunststoffmaterial des Gehäusekörpers wird vorzugsweise ein thermoplastischer oder duroplastischer Kunststoff wie zum Beispiel Polyphtalamid verwendet.

Das Umhüllungsmaterial kann unter anderem zur mechanischen Stabilisierung zusätzlich vorzugsweise mit Glasfasern oder Mineralfüllstoff versetzt sein.

Besonders bevorzugt eignet sich das erfindungsgemäße Bauelement zur Herstellung von Leuchtdiodenbauelementen mit Halbleiterchips, bei denen zumindest die strahlungsemittierende Zone zumindest teilweise aus einem auf GaN basierenden Halbleitermaterial, insbesondere aus einem GaN-, InGaN-, AlGaN- und/oder InGaAlN-Halbleitermaterial besteht. Das Emissionsspektrum von derartigen Halbleiterchips liegt, abhängig von der jeweils vorliegenden Zusammensetzung üblicherweise zu einem wesentlichen Teil im blauen und/oder ultravioletten Spektralbereich.

Die Ausnehmung des Gehäusekörpers ist vorzugsweise mit einem zumindest für einen Teil der vom Halbleiterchip ausgesandten Strahlung durchlässigen Material gefüllt. Zur Herstellung von mischfarbigem Licht abstrahlenden Leuchtdiodenbauelementen und/oder zur Umwandlung eines ultravioletten oder blauen Strahlungsanteiles des Chips in längerwellige Strahlung kann das durchlässige Material mit Leuchtstoffpartikel versetzt sein, die zumindest einen Teil der elektromagnetischen Strahlung mit Wellenlängen aus dem ultravioletten und/oder blauen Spektralbereich absorbiert und im Vergleich zu dieser längerwellige, insbesondere für das menschliche Auge sichtbare bzw. besser sichtbare elektromagnetische Strahlung aussenden.

Die obigen sowie weitere Vorteile und Merkmale der vorliegenden Erfindung ergeben sich aus dem im Folgenden in Verbindung mit den beiliegenden Zeichnungen näher erläuterten Ausführungsbeispiel. Es zeigen:
FIG 1 eine schematische Darstellung eines oberflächenmontierbaren optoelektronischen Bauelements, bei dem die vorliegende Erfindung eingesetzt werden kann;
FIG 2A bis 2C verschiedene Reflexionsspektren für unterschiedliche Materialien die gemäß der vorliegenden Erfindung als Füllstoffe in dem Kunststoffmaterial des Gehäusekörpers des in FIG 1 dargestellten Bauelements verwendet werden können; und
FIG 3 ein Reflexionsspektrum für einen Gehäusekörper eines optoelektronischen Bauelements gemäß dem Stand der Technik.

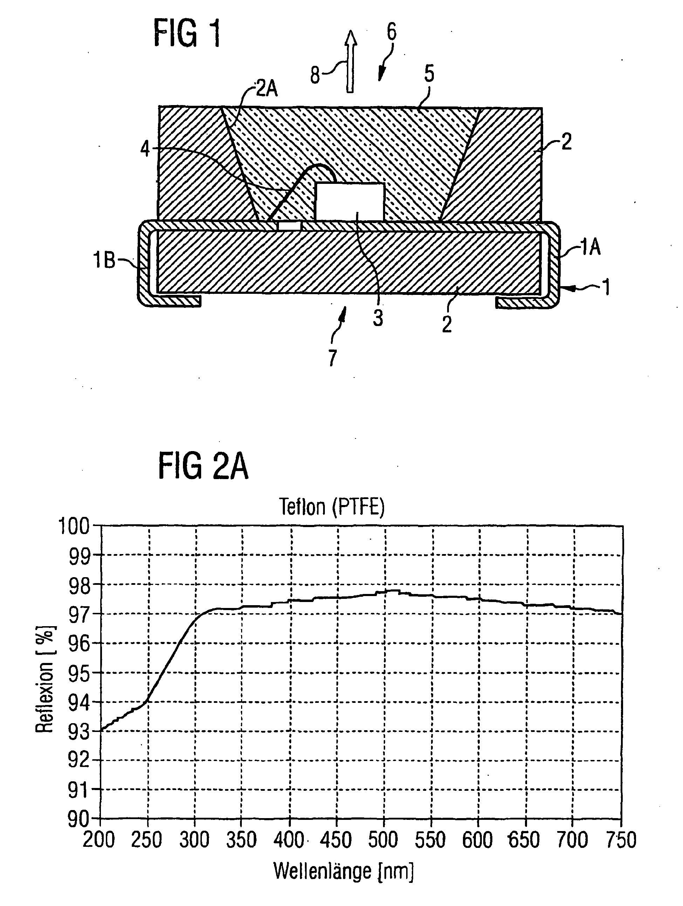

In FIG 1 ist eine schematische Darstellung eines zu einer Gehäuse-Montageseite 7 vertikalen Querschnitts durch ein optoelektronisches Bauelement dargestellt, bei dem die vorliegende Erfindung zum Einsatz kommt. Der Gehäusekörper 2 ist durch Umspritzen eines Leadframes 1 mit einem geeigneten Kunststoffmaterial unter gleichzeitiger Formung des Gehäusekörpers 2 gebildet. Der Gehäusekörper 2 weist eine vorzugsweise mittig zum Gehäusekörper angeordnete Ausnehmung 6 auf. In dieser ist ein Halbleiterchip 3, wie zum Beispiel ein optoelektronischer Sender oder Empfänger, vorliegend beispielsweise ein auf GaN-, InGaN-, AlGaN- und/oder InGaAlN-Halbleitermaterial basierender Leuchtdiodenchip, angeordnet. Elektrische Kontaktflächen des Chips 3 sind mit elektrischen Anschlüssen 1A, 1B des Leadframes 1 mittels eines Bonddrahtes 4 bzw. mittels eines elektrisch leitenden Verbindungsmittels zum Chipbonden elektrisch leitend verbunden.

Die Innenflächen 2A der Ausnehmung 6 des Gehäusekörpers 2 sind derart schräg ausgebildet, dass sie eine vom Chip 3 zur Seite hin ausgesandte Strahlung zumindest zu einem großen Teil zu einer Abstrahlrichtung 8 des Chips 3 hin umlenken. Durch die nachfolgend beschriebene Auswahl eines geeigneten Materials für den Gehäusekörper 2 mit einem hohen Reflexionsvermögen dienen diese schrägen Innenflächen 2A als Reflektoren, um die Abstrahlleistung bzw. die Empfangsempfindlichkeit des optoelektronischen Bauelements zu erhöhen.

Der optoelektronische Halbleiterchip 3 ist in einem zumindest für einen Teil der von diesem ausgesandten elektromagnetischen Strahlung zumindest teilweise durchlässigen Ummantelungsmaterial 5 eingebettet. Die dem Halbleiterchip 3 abgewandte Oberfläche des Ummantelungsmaterials 5 schließt dabei vorliegend im wesentlichen mit der Oberfläche des Gehäusekörpers 2 ab. Es wird aber darauf hingewiesen, dass im Rahmen der vorliegenden Erfindung je nach Bedarf selbstverständlich auch andere Füllhöhen des Ummantelungsmaterials 5 in der Ausnehmung 6 des Trägerkörpers 1 gewählt sein können. Ferner kann auf den so gebildeten Gehäusekörper 2 mit Ummantelungsmaterial 5 auch eine geeignete optische Einrichtung wie beispielsweise eine optische Linse aufgebracht werden, um die optischen Eigenschaften des Bauelements an spezielle Anwendungsmöglichkeiten anzupassen.

Als Material für das Ummantelungsmaterial 5 wird üblicherweise ein strahlungsdurchlässiges Material eingesetzt, das vorzugsweise UV-initiiert oder Licht-initiiert härtende Eigenschaften besitzt. Ein besonders bevorzugtes Ummantelungsmaterial 5 enthält ein UV-initiiert oder Licht-initiiert härtendes Epoxidharz, das durch Beaufschlagung mit Licht- oder UV-Strahlung innerhalb weniger Sekunden angehärtet bzw. vorfixiert und zu einem späteren Zeitpunkt thermisch vollständig ausgehärtet wird.

Je nach Wahl des Materials des Gehäusekörpers 2 und den gewünschten optischen Eigenschaften des optoelektronischen Bauelements enthält das Ummantelungsmaterial 5 neben seinem Hauptbestandteil des oben angegebenen Epoxidharzes weitere Anteile, um die Verbindungsstärke mit dem Gehäusekörpermaterial, die Anhärte- und Aushärtezeit, die Lichtdurchlässigkeit, den Brechungsindex, die Temperaturbeständigkeit, die mechanische Härte, etc. wunschgemäß einzustellen.

Zur Herstellung von mischfarbigem Licht abstrahlenden Leuchtdiodenbauelementen und/oder zur Umwandlung eines ultravioletten oder blauen Strahlungsanteiles des Chips in längerwellige Strahlung ist das Ummantelungsmaterial 5 mit Leuchtstoffpartikel versetzt. Diese absorbieren zumindest einen Teil der vom Chip 3 ausgesandten elektromagnetischen Strahlung, zum Beispiel mit Wellenlängen aus dem ultravioletten und/oder blauen Spektralbereich, und emittieren dann elektromagnetische Strahlung mit im Vergleich zur absorbierten Strahlung größeren, insbesondere für das menschliche Auge sichtbaren bzw. besser sichtbaren Wellenlängen.

Für den Gehäusekörper 2 des Bauelements wird ein Umhüllungsmaterial eingesetzt, das bestimmte Füllstoffe enthält. Dieses Umhüllungsmaterial, das den Hauptbestandteil des Gehäusekörpers 2 bildet, wird dabei bevorzugt aus einem thermoplastischen oder duroplastischen Kunststoff gebildet. Besonders geeignet ist hierfür beispielsweise Polyphtalamid, welches zur mechanischen Stabilisierung mit Glasfasern versetzt sein kann.

Ein geeigneter Füllstoff ist Teflon (PTFE), dessen Reflexionsvermögen im Diagramm von FIG. 2A dargestellt ist. Wie man dem Reflexionsspektrum von FIG 2A entnehmen kann, zeigt Teflon in einem Bereich von etwa 300 bis 800 nm ein sehr hohes Reflexionsvermögen von deutlich über 90%.

Aufgrund dieses hohen Reflexionsvermögens auch für Wellenlängen unterhalb von 500 nm, wird von den Innenflächen 2A des Gehäusekörpers 2 auch blaues Licht und UV-Licht reflektiert. Somit zeigt das Bauelement mit einem derartigen Gehäusekörper auch für Anwendungsfälle in diesem Spektralbereich einen guten Wirkungsgrad, da ein höherer Anteil der von dem Halbleiterchip 3 erzeugten Strahlung von dem Bauelement emittiert bzw. ein höherer Anteil der von dem Bauelement empfangenen Strahlung durch den Halbleiterchip 3 detektiert werden kann.

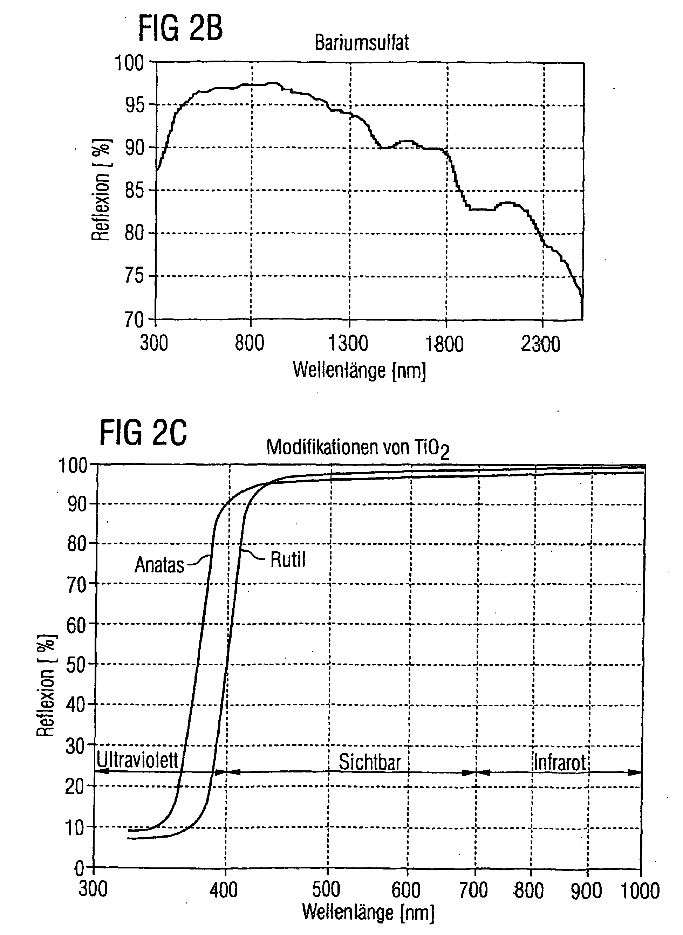

Als zusätzlicher Füllstoff, der mit einem Volumenanteil von etwa 5 bis 15 %, vorzugsweise 8 bis 12 % und besonders bevorzugt ungefähr 10 % zugegeben wird, ist vorteilhafterweise Bariumsulfat (BaSO₄) benutzt. Bariumsulfat ist ein Material, das in einem Wellenlängenbereich zwischen etwa 350 und 800 nm ein Reflexionsvermögen von mehr als 90 % aufweist, wie dies in dem Reflexionsspektrum von FIG 2B dargestellt ist.

Außerdem ist vorteilhafterweise durch die Zugabe des Füllstoffes der Gehäusekörper 2 im Vergleich zu herkömmlichen Gehäusekörpern alterungsstabiler, da weniger Absorptionsenergie in dem Gehäusekörper auftritt. Da Bariumsulfat nicht nur unterhalb von 500 nm sondern bis in den Infrarotbereich ein sehr hohes Reflexionsvermögen besitzt, ist ein optoelektronisches Bauelement mit einem solchen Gehäusekörper universell einsetzbar.

Ein weiterer geeigneter Füllstoff ist Anatas, eine besondere Modifikation von TiO₂, dessen Reflexionsspektrum im Diagramm von FIG 2C gezeigt ist. Im Diagramm von FIG.2 ist zum Vergleich das Reflexionsvermögen des bisher verwendeten Rutils aufgetragen. Anatas ist wie Rutil eine besondere Modifikation von TiO₂, wobei die Titan- und Sauerstoffatome im Falle von Rutil dichter gepackt sind und Rutil eine höhere Dichte und eine höhere Brechzahl als Anatas aufweist.

Es wird von der Erkenntnis ausgegangen, dass ein Füllstoff mit einem hohen Reflexionsvermögen auch im blauen und/oder im UV-Bereich zu verwenden ist.

## Patentansprüche

1. Optoelektronisches Bauelement mit einem aus einem Umhüllungsmaterial gefertigten Gehäusekörper (2), einem an dem Gehäusekörper (2) angeordneten optoelektronischen Halbleiterchip (3) und mit elektrischen Anschlüssen (1A, 1B), mit denen der Halbleiterchip (3) elektrisch leitend verbunden ist,
wobei das Umhüllungsmaterial einen Füllstoff enthält,
**dadurch gekennzeichnet, dass**
der Füllstoff ein Material aus der Gruppe bestehend aus Anatas und Polytetrafluorethylen oder eine Mischung aus diesen Materialien aufweist.

2. Optoelektronisches Bauelement nach Anspruch 1,
**dadurch gekennzeichnet, dass**
der Anteil des Füllstoffes in dem Umhüllungsmaterial zwischen einschließlich 5 Vol.% und einschließlich 50 Vol.%, insbesondere zwischen einschließlich 5 Vol.% und einschließlich 15 Vol.% beträgt.

3. Optoelektronisches Bauelement nach Anspruch 1 oder 2,
**dadurch gekennzeichnet, dass**
der Füllstoff zusätzlich Bariumsulfat aufweist.

4. Optoelektronisches Bauelement nach einem der vorhergehenden Ansprüche,
**dadurch gekennzeichnet, dass**
das Umhüllungsmaterial ein thermoplastischer oder duroplastischer Kunststoff ist.

5. Optoelektronisches Bauelement nach Anspruch 4,
**dadurch gekennzeichnet, dass**
das Umhüllungsmaterial Polyphtalamid ist.

6. Optoelektronisches Bauelement nach einem der vorhergehenden Ansprüche,
**dadurch gekennzeichnet, dass**
das Umhüllungsmaterial mit Glasfasern oder Mineralfüllstoff versetzt ist.

7. Optoelektronisches Bauelement nach einem der vorhergehenden Ansprüche,
**dadurch gekennzeichnet, dass**
der Halbleiterchip eine strahlungsemittierende Zone enthält,
die zumindest teilweise aus einem auf GaN basierenden Halbleitermaterial, insbesondere aus einem GaN-, InGaN-, AlGaN- und/oder InGaAlN-Halbleitermaterial besteht.

8. Optoelektronisches Bauelement nach einem der vorhergehenden Anprüche,
**dadurch gekennzeichnet, dass**
der Halbleiterchip eine strahlungsemittierende Zone enthält, die elektromagnetische Strahlung mit Wellenlängen aus dem ultravioletten Spektralbereich aussendet.

9. Optoelektronisches Bauelement nach Anspruch 8,
**dadurch gekennzeichnet, dass**
der Gehäusekörper (2) eine Ausnehmung (6) aufweist, in der
der Halbleiterchip (3) angeordnet ist, und die Ausnehmung mit einem zumindest für einen Teil der vom Halbleiterchip : ausgesandten Strahlung durchlässigen Material gefüllt ist,
das Leuchtstoffpartikel enthält, die zumindest einen Teil der elektromagnetischen Strahlung mit Wellenlängen aus dem ultravioletten Spektralbereich absorbiert und im Vergleich zu dieser längerwellige elektromagnetische Strahlung aussenden.

10. Optoelektronisches Bauelement nach Anspruch 9,
**dadurch gekennzeichnet, dass**
die längerwellige elektromagnetische Strahlung Wellenlängen
aus dem für das menschliche Auge sichtbaren Spektralbereich aufweist.

11. Optoelektronisches Bauelement nach einem der Ansprüche 1 bis 8,
**dadurch gekennzeichnet, dass**
der Gehäusekörper (2) eine Ausnehmung (6) aufweist, in der der Halbleiterchip (3) angeordnet ist.

12. Optoelektronisches Bauelement nach einem der Ansprüche 9 bis 11,
**dadurch gekennzeichnet, dass**
die Ausnehmung (6) als Reflektor von zumindest einem Teil der vom Halbleiterchip (3) ausgesandten Strahlung ausgebildet ist.

## Claims

1. Optoelectronic component having a housing body (2) produced from an encapsulation material, an optoelectronic semiconductor chip (3) arranged at the housing body (2), and having electrical terminals (1A, 1B), to which the semiconductor chip (3) is electrically conductively connected,
wherein
the encapsulation material contains a filler, **characterized in that** the filler comprises a material from the group consisting of anatase and polytetrafluoroethylene or a mixture comprising these materials.

2. Optoelectronic component according to Claim 1,
**characterized in that**
the proportion of the filler in the encapsulation material is between 5% by volume and 50% by volume inclusive, in particular between 5% by volume and 15% by volume inclusive.

3. Optoelectronic component according to Claim 1 or 2,
**characterized in that**
the filler additionally comprises barium sulfate.

4. Optoelectronic component according to one of the preceding claims,
**characterized in that**
the encapsulation material is a thermoplastic or a thermosetting plastic.

5. Optoelectronic component according to Claim 4,
**characterized in that**
the encapsulation material is polyphthalamide.

6. Optoelectronic component according to one of the preceding claims,
**characterized in that**
the encapsulation material is admixed with glass fibers or mineral filler.

7. Optoelectronic component according to one of the preceding claims,
**characterized in that**
the semiconductor chip contains a radiation-emitting zone, which at least partly comprises a GaN-based semiconductor material, in particular a GaN, InGaN, AlGaN and/or InGaAlN semiconductor material.

8. Optoelectronic component according to one of the preceding claims,
**characterized in that**
the semiconductor chip contains a radiation-emitting zone, which emits electromagnetic radiation having wavelengths from the ultraviolet spectral range.

9. Optoelectronic component according to Claim 8,
**characterized in that**
the housing body (2) has a recess (6), in which the semiconductor chip (3) is arranged, and the recess is filled with a material which is transmissive at least to part of the radiation emitted by the semiconductor chip and contains luminescent material particles which absorb at least part of the electromagnetic radiation having wavelengths from the ultraviolet spectral range and emit longer-wave electromagnetic radiation in comparison therewith.

10. Optoelectronic component according to Claim 9,
**characterized in that**
the longer-wave electromagnetic radiation has wavelengths from the spectral range that is visible to the human eye.

11. Optoelectronic component according to one of Claims 1 to 8,
**characterized in that**
the housing body (2) has a recess (6), in which the semiconductor chip (3) is arranged.

12. Optoelectronic component according to one of Claims 9 to 11,
**characterized in that**
the recess (6) is formed as a reflector of at least part of the radiation emitted by the semiconductor chip (3).

## Revendications

1. Composant optoélectronique avec un corps de boîtier (2) fabriqué dans un matériau d'enrobage, une puce semi-conductrice optoélectronique (3) disposée sur le corps de boîtier (2) et avec des connexions électriques (1A, 1B) reliant électriquement la puce semi-conductrice (3), le matériau d'enrobage contenant une substance de remplissage, **caractérisé en ce que** la substance de remplissage comporte un matériau du groupe constitué d'anatase et de polytétrafluoréthylène ou d'un mélange de ces matériaux.

2. Composant optoélectronique selon la revendication 1, **caractérisé en ce que** la proportion de substance de remplissage dans le matériau d'enrobage vaut entre 5% en volume inclus et 50% en volume inclus, notamment entre 5% en volume inclus et 15% en volume inclus.

3. Composant optoélectronique selon la revendication 1 ou 2, **caractérisé en ce que** la substance de remplissage comporte de plus du sulfate de baryum.

4. Composant optoélectronique selon une des revendications précédentes, **caractérisé en ce que** le matériau d'enrobage est une substance synthétique thermoplastique ou thermodurcissable.

5. Composant optoélectronique selon la revendication 4, **caractérisé en ce que** le matériau d'enrobage est du polyphtalamide.

6. Composant optoélectronique selon une des revendications précédentes, **caractérisé en ce que** le matériau d'enrobage est mélangé à des fibres de verre ou à une substance de remplissage minérale.

7. Composant optoélectronique selon une des revendications précédentes, **caractérisé en ce que** la puce semi-conductrice contient une zone émettrice de rayonnement composée au moins partiellement d'un matériau semi-conducteur basé sur du GaN, notamment d'un matériau semi-conducteur de GaN, InGaN, AlGaN et/ou de InGaAlN.

8. Composant optoélectronique selon une des revendications précédentes, **caractérisé en ce que** la puce semi-conductrice contient une zone émettrice de rayonnement émettant du rayonnement électromagnétique ayant des longueurs d'ondes appartenant à la plage spectrale des ultraviolets.

9. Composant optoélectronique selon la revendication 8, **caractérisé en ce que** le corps de boîtier (2) comporte un évidement (6) dans lequel est disposée la puce semi-conductrice (3), et l'évidement est rempli d'un matériau transparent pour au moins une partie du rayonnement émis par la puce semi-conductrice, contenant des particules de substance luminescente absorbant au moins une partie du rayonnement électromagnétique ayant des longueurs d'ondes appartenant à la plage spectrale des ultraviolets et émettant un rayonnement électromagnétique de longueur d'onde plus élevée par rapport à celle-ci.

10. Composant optoélectronique selon la revendication 9, **caractérisé en ce que** le rayonnement électromagnétique de longueur d'onde plus élevée comporte des longueurs d'ondes de la plage spectrale visible pour l'oeil humain.

11. Composant optoélectronique selon une des revendications 1 à 8, **caractérisé en ce que** le corps de boîtier (2) comporte un évidement (6) dans lequel est disposée la puce semi-conductrice (3).

12. Composant optoélectronique selon une des revendications 9 à 11, **caractérisé en ce que** l'évidement (6) est développé en réflecteur pour au moins une partie du rayonnement émis par la puce semi-conductrice (3).
